# EUROPEAN PATENT SPECIFICATION

(11) **EP 0 390 789 B1**
(45) Date of publication and mention of the grant of the patent: **15.12.1993**
(21) Application number: 88909110.4
(22) Date of filing: 14.10.1988
(51) Int. Cl.: H01F 7/22, H01L 39/14

(54) **SUPERCONDUCTING STRUCTURES**
SUPRALEITENDE ANORDNUNGEN
STRUCTURES SUPRACONDUCTRICES

(30) Priority: 14.10.1987 GB 8724126
(43) Date of publication of application: 10.10.1990
(73) Proprietor: OXFORD MEDICAL LIMITED, Osney Mead, Oxford, OX2 0DX (GB); CAMBRIDGE ADVANCED MATERIALS LIMITED, Cambridge CB1 3PW (GB)
(72) Inventor: MCDOUGALL, Ian, Leitch, Charlbury Oxon (GB); EVETTS, Jan, Edgar, 193 Coleridge Road Cambridge CB1 3PW (GB)
(74) Representative: Skone James, Robert Edmund
(86) International application number: GB8800861
(87) International publication number: WO8903581

(56) References cited:
- EP-A- 0 141 124
- GB-A- 1 184 674
- US-A- 3 956 724
- Patent Abstracts of Japan, vol. 10, no. 251, (E-342)(2307), 28 August 1986; & JP-A-6 180 809

## Description

This invention concerns superconducting structures, particularly monolithic superconducting structures for the levitation, control and drive of magnetic armatures and structures for superconducting magnets.

A unique and characteristic feature of a superconductor is its tendancy to exclude magnetic flux. This is known as the Meissner Effect and for low applied magnetic fields results in perfect diamagnetism, or the total exclusion of all magnetic flux from the main body of a superconductor. In practice the diamagnetism is never quite perfect. There is always some penetration of magnetic flux at the surface of a superconductor. Furthermore in Type 2 superconductors and with high applied magnetic fields, appreciable magnetic flux can penetrate into the body of the superconductor. These departures from a perfect Meissner Effect, although important, do not affect the principles of the invention described.

Immediate application of the Meissner Effect is seen in the ability of a superconducting plate or sheet to levitate a magnetic body. This phenomenon can be understood in terms of the magnetic body resting on a compressed region of its own magnetic flux; the magnetic flux is compressed between the source (i.e. the magnetic body) and the superconducting sheet, from which magnetic flux is partially or completely excluded on account of the Meissner Effect. The magnetic pressure resulting from the compression of the magnetic flux, and the consequent raising of the magnetostatic field energy stored in the magnetic flux, leads to an upward force of levitation on the magnetic body and an equal and opposite downward reaction on the superconductor.

The calculation of the magnetic flux compression and magnetic field intensity around a levitating body involves magnetostatics and electrodynamics. However a first approximation may be arrived at by a method of images. Thus when a magnetic body is placed near a superconducting sheet the distribution of magnetic flux outside the superconductor can be approximated by the superposition of the original flux distribution in the absence of the superconductor and the flux distribution of a notional magnetic image of the magnetic body, located appropriately after the manner of images. Thus a levitated magnetic body can be viewed rather simply as floating above its own image within the superconductor. Whenever the initial magnetic body moves or rotates, its image moves accordingly to compensate and thereby maintain levitation. It is the inherent dynamic stability of this process that is the fundamental difference between a magnetic body levitated over a superconductor and a magnet supported by repulsion from another magnet.

A further consequence of the Meissner Effect is that a superconducting plate or sheet acts as a screen which prevents a magnetic influence on one side of the plate or sheet from interacting with or influencing a magnetic body on the other side. This makes it difficult to control the aspect of, or induce controlled motion or drive in, a levitated magnetic body, by the use of control currents or magnets situated below the superconducting sheet or plate.

Many currently available high critical temperature superconductors show exceptional anisotropy in their ability to carry currents. This feature has both desirable and undesirable aspects. For many applications it may be necessary to orientate the crystalline texture of the superconductor so as to line up the c-axis of the single-crystal or polycrystals in a particular direction.

EP-A-0141124 discloses sets of multi-filament zones made up of superconducting filaments arranged in a matrix.

In accordance with the present invention a superconducting structure comprises a tessellated arrangement of separate superconducting sub-units characterized in that each sub-unit is in the shape of a Bitter disk.

The invention enables the construction of a superconducting magnetic field generator from superconductors with poor mechanical properties. For example, many superconducting substances, especially type II superconducting alloys, such as Niobium-Titanium (NbTi) and Niobium-Tin (Nb₃Sn), and the recently discovered high temperature superconducting ceramics, such as Yttrium Barium Copper Oxide, have very poor mechanical properties. This is particularly a problem with the ceramics where strain to failure is very low and often the fracture toughness is also very low. Hence, it is very difficult to manufacture a conventional type of superconducting magnet from these ceramics by winding them in wire form around even large radii.

In a preferred embodiment each tile or sub-unit is electrically connected to its immediate neighbours. However, in an alternative embodiment each tile is completely electrically insulated from the other tiles in the stack. In the latter case the magnetic field generator may be powered by a pulse discharge source which induces a current in the tiles, which in turn generates a magnetic field.

In either case each pair of the tiles is preferably spaced apart by an insulating substrate.

In one application there are a number of separate stacks of tiles arranged in an array so that the central axes of the stacks are parallel to each other.

For certain applications the surface of a tile may be ribbed or otherwise patterned to import an important anisotropy, for example to its interaction with a levitated magnetic body.

Furthermore the tiles need not be simply connected and may enclose other tiles inserted within designed apertures in their planar surfaces. Alternatively, there may be apertures in the tiles to allow for the passage of a refrigerant or coolant between the tiles.

Preferably, the tiles or sub-units comprise ceramic superconductors.

It is envisaged that the mix or ratio of types of tile may vary across a section of tessellated monolith. Thus tiles with current leads may be substituted by similarly shaped tiles without leads. Also tiles or parts of tiles may be substituted by permanent magnet tiles or by inert spacer tiles.

When it is necessary to make electrical connections between tiles this may be a normal conductor or a superconductor.

It is envisaged that the superconducting tiles will require stabilisation and protecting using coatings and techniques as described in previous copending British patent applications Nos. 8705018, 8710113, 8714993 and 8717506.

In a preferred embodiment the tiles are formed by powder fabrication which imports a strong c-axis texture, such that crystalline c-axis directions in the polycrystalline sintered product has a strong crystallographic texture favouring a direction normal to the plane of the tile. One way of achieving this texture is to initially compact the powder under strong uni-axial compression forces.

In a further embodiment the tiles consist of single crystals of high critical temperature superconductor orientated with c-axis normal to the plane of the tile.

In a further embodiment the tile consists of a thick or thin superconducting film deposited as a tile shaped substrate incorporating electrical contacts and current leads. The deposited film may also have a strong c-axis texture with its normal perpendicular to the plane of the substrate. Alternatively, it may be important to use epitaxial single-crystal or near single-crystal films with the c-axis perpendicular to the plane of the substrate.

When the tiles consist of deposited films on shaped substrates it may be advantageous to deposit a main passive levitation layer followed by an insulating layer and then a further superconducting layer which may subsequently be post-processed using a lithographic techniques to provide the necessary current leads in the form of an array of wires as a network or a mesh. It may be important to incorporate additional non-superconducting layers during the deposition stage. Such layers would be of importance as etch-stops during processing or as lithographic masks at other stages of the processing. Furthermore such additional layers or bilayers may perform the function of protection or stabilisation of the superconductor in or forming the tile, according to techniques described in previous copending patent applications herein referred to.

Furthermore it is envisaged that tiles may be cut from a sheet of material formed when ductile in a manner so as to achieve the desired shape and texture and then subsequently rendered into an optimum superconducting state as by annealing in oxygen or by the techniques described in the previous copending British patent applications herein referred to. The appropriate starting material may be rendered ductile by using techniques described in the previous copending patent applications herein referred to.

Particular applications of the tessellated monolithic structures described are envisaged in the positioning, rotating and translational drawing of magnetic bodies (generalised armatures) over flat, curved, horizontal and sloping tessellated surfaces.

A further application is envisaged in the support of rotating bearing shafts and bearing housings of generalised design.

A further application is envisaged in motors, moving shafts, actuators and precision drives.

Further applications are envisaged in the transport of material or objects, and in the separation and sorting of objects as in mineral separation.

Some examples of tile structures and a Bitter magnet according to the invention will now be described by way of example with reference to the accompanying drawings in which:-
Figure 1a is a plan view of a tile;
Figure 1b is a cross-section through the tile of Figure 1a;
Figure 2a shows an array of such tiles, in plan view;
Figure 2b is a section through Figure 2a on the line AA';
Figure 3 shows a plan view of a tile in the shape of a Bitter disk; and,
Figure 4 is a cross-sectional view of a stack of Bitter disk shaped tiles forming a magnetic field generator.

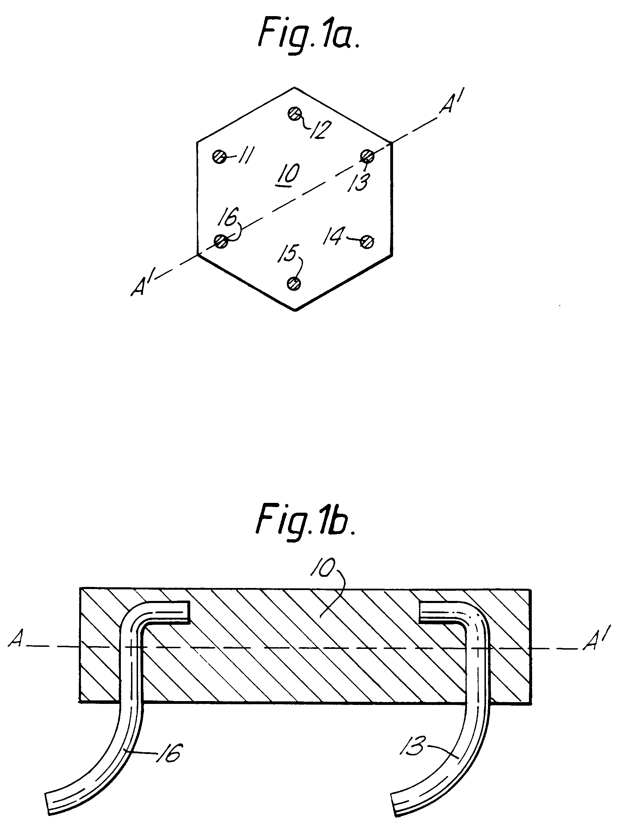

Figures 1a and 1b illustrate a hexagonal tile 10 having six current leads as described above numbered 11 to 16. In Figure 1b contact leads 13 and 16 are shown in section.

The dimension of the tile 10 may be in the range 25 to 150 mm across flats and the wires may be of diameter 0.5 to 3 mm.

The wires may be of a conducting material coated or electroplated with silver, gold, silver-gold alloy or silver-palladium alloy. Furthermore the wires may be composite and include normal conducting regions, insulating regions and superconducting regions.

For certain applications the conductors may form an array, network or mesh of conductors formed on a thin film fixed or deposited on the surface of the tile but insulated from the main superconducting body of the tile.

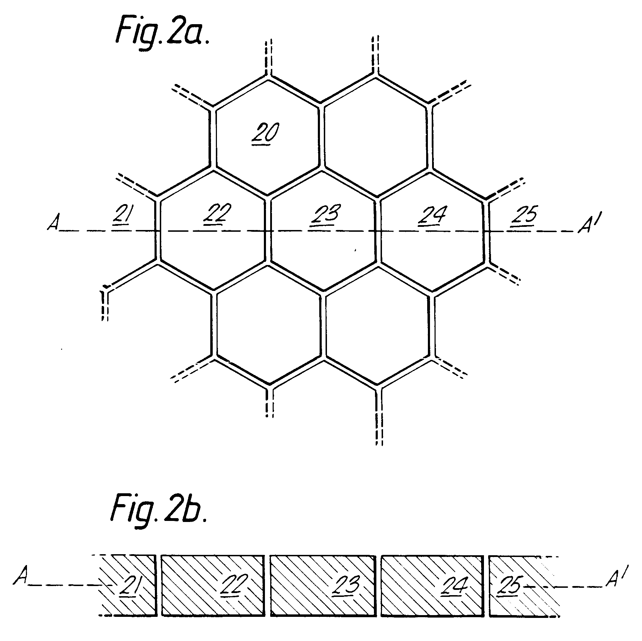

A variety of types of regular tessellation can be used to achieve a proper response in levitated magnetic bodies. All the regular two dimensional space groups offer symmetry aspects of interest in particular applications. In a particular embodiment of the tessellations, hexagonal tiles may be arranged in a hexagonal tessellation as shown in Figure 2a. Particular hexagonal tiles are numbered 20 to 25. The individual tiles may be as described previously in relation to Figure 1a and Figure 1b.

### Example

In order to test the tessellation of a curved surface with a close packed array of tiles twenty five hexagonal tiles were fabricated. A hexagonal steel cylinder with a closely fitting hexagonal piston was constructed with a dimension of 20mm across the flats. The cylinder was placed on a steel base plate and sufficient YBa₂Cu₃O₇ to make a dense tile 2.5mm thick was poured evenly into the cylinder. The piston was used to compress the powder to a pressure of 30MPa, after initial compaction small amounts of powder were added to the cylinder sufficient to make the tile of uniform final thickness 3mm, this was again compacted to 30MPa. The compacted tile was then heat treated in flowing oxygen to obtain a hard sintered monolith with optimum superconductivity properties. The optimum heat treatment depends on the thickness and density of tile, the heat treatment chosen was 950°C for 24 hours followed by slow cooling at 1°C per minute to 600°C where isothermal heat treatment was continued for 8 hours, after cooling at 1°C per minute to 350°C, heat treatment was continued for another 12 hours. Finally the sample was cooled slowly at 1°C per minute. X-ray diffraction analysis of the compound in the finished tile gave the same result as for the powder except for a partial crystalline texture taking the form of a tendency for the crystalline c-axis to lie parallel to the compaction axis.

Nineteen tiles were assembled to tessellate a shallow hexagonal shaped concave surface with approximate diameter 100mm and depth 5mm. The tile assembly was cooled to 77K and was able to levitate a small disc shaped permanent magnet of diameter 10mm which could be moved freely over the area of tessellation whilst remaining levitated at a constant height of 4mm above the tiles.

One of the tiles was fabricated with four silver electrical contact wires of diameter 0.4mm. The wires were inserted into the compaction cylinder through small holes in the steel base plate and turned over at their ends as depicted in Figure 2. The powdered YBa₂Cu₃O₇ was then poured evenly into the cylinder and the same procedure as described previously was carried out to compact and heat treat the tile. After cooling to 77K two of the contact wires were used to pass an electric current into the tile and the second pair of wires were used to monitor the voltage to check that the tile remained fully superconducting. The tile was placed in the centre of a hexagonal array of seven tiles and a rectangular permanent magnet of dimensions 12mm x 3mm x 0.5mm was levitated over the tile with electrical contact wires; as the electric current through the central tile was increased the levitated magnet was observed to rotate. The rotation increased with increasing current reaching a maximum of about 30° rotation for a current of 1.3 amperes. As the current was varied up and down the angle of rotation of the magnet increased and decreased demonstrating how according to the invention an electric current passed through the tile from an external source can be used to control the position of a levitated magnet.

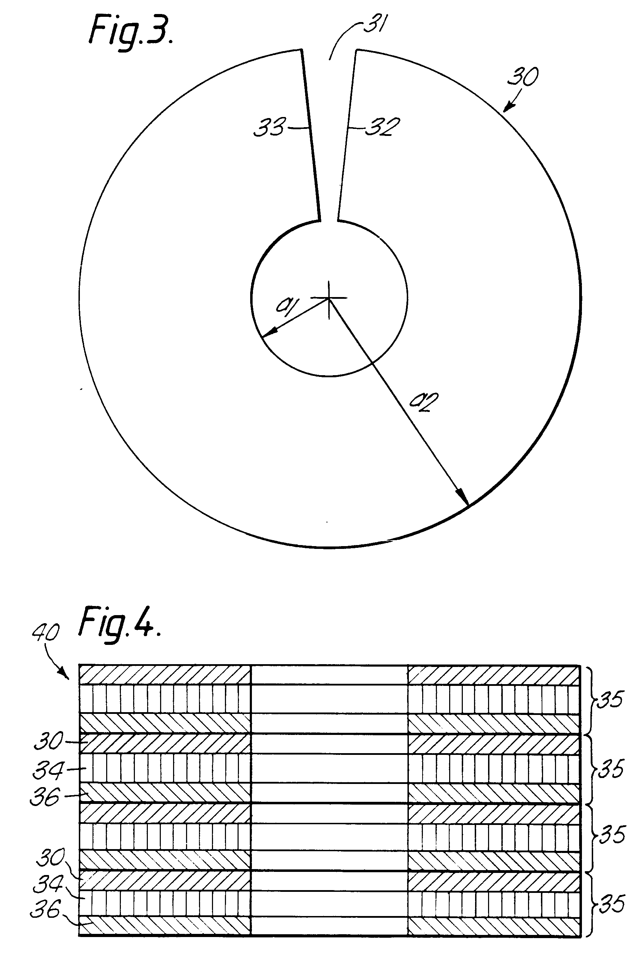

Figure 3 shows an example of the invention in which a tile 30 is in the shape of a Bitter disk. The tile 30 has a slit 31 and this slit defines two radial edges 32, 33. The tile 30 has an inner radius a₁ and an outer radius a₂.

Conventional Bitter disk shaped electromagnets operate in the resistive mode and hence, if a constant potential difference is applied between the edges 33 and 32, the current density in the Bitter disk is inversely proportional to the radius. This is because at the innermost edge of the disk, defined by the radius a₁, the current path is shorter and hence the resistance is less than at the outermost edge of the disk, defined by the radius a₂, where the current path is longer and hence the resistance is greater. Due to this current distribution in the Bitter disk the magnet has a higher efficiency than a wire wound magnet of the same geometry.

When the Bitter disk operates in the superconducting mode there is no resistance in the disk and hence there is no power dissipation, and due to inductive effects in the disk, the current density varies directly with the radius of the disk. It can be shown that if the superconductor is a thin disk, the maximum possible current density is inversely proportional to the magnetic field to a first approximation. Hence, the maximum field is where the current density is smallest and this is at the smallest radius of the Bitter disk, i.e. a₁ in Figure 3. Therefore, a superconducting magnet of the Bitter disk form has a higher efficiency than a wire wound superconducting magnet of the same geometry.

In practice, a number of composite Bitter disks 35 are assembled together, as shown in Figure 4, to form a stack. Each composite Bitter disk 35 comprises a layer of insulating substrate 34 such as zirconium, a tile 30 which is a layer of ceramic superconductor, such as Yttrium Barium Copper Oxide, and a layer of silicon rubber 36 on the other side of the substrate 34 from the tile 30 which spreads the load between the disks 35.

This type of construction for a superconducting magnet is mechanically strong as it resists the expansive hoop stresses of the magnet, particularly because there is no mechanical discontinuity across the radius of the disk. Any axial compression present is well accommodated by the fixed face contact of the disks 35 and the presence of the silicon rubber load spreading layer 36.

Each tile 30 in each Bitter disk 35 may be connected to the immediate adjacent tile 30 so that a current may be passed through the tiles 30 to generate a magnetic field. Alternatively, each tile 30 may be electrically isolated from the other tiles 30 and a current induced in the tiles by a pulsed discharge source so that the induced current produces a magnetic field.

It would also be possible to have an array of separate stacks with the central axes of the stacks parallel to each other. This arrangement would generate a field outside the stacks of Bitter disks but close to them.

## Claims

1. A superconducting structure comprising a tessellated arrangement of separate superconducting sub-units (30) characterized in that each sub-unit (30) is in the shape of a Bitter disk.

2. A superconducting structure according to claim 1, wherein each sub-unit (30) is electrically connected to the sub-units immediately adjacent to it so as to form a superconducting magnet (40).

3. A superconducting structure according to claim 1 or claim 2, further comprising a number of layers of insulating substrate to electrically isolate the sub-units (30) from each other.

4. A superconducting structure according to any of the preceding claims, further comprising a number of resilient layers (36).

5. A superconducting structure according to any of the preceding claims, wherein each sub-unit (30) comprises a ceramic superconductor.

6. A superconducting structure according to any of the preceding claims, in combination with a magnetic armature.

7. A number of superconducting structures according to any of the preceding claims, arranged in an array with their central axes substantially parallel.

## Patentansprüche

1. Eine supraleitende Struktur, die eine mosaikförmige Anordnung von getrennten, supraleitenden Untereinheiten (30) umfaßt, **dadurch gekennzeichnet**, daß jede Untereinheit (30) in der Form einerBitter-Scheibe ist.

2. Eine supraleitende Struktur gemäß Anspruch 1, in der jede Untereinheit (30) elektrisch mit den ihr unmittelbar benachbarten Untereinheiten so verbunden ist, einen supraleitenden Magneten (40) zu bilden.

3. Eine supraleitende Struktur gemäß Anspruch 1 oder Anspruch 2, die ferner eine Anzahl von Schichten eines isolierenden Substrats umfaßt, um die Untereinheiten (30) elektrisch voneinander zu isolieren.

4. Eine supraleitende Struktur gemäß irgendeinem der vorhergehenden Ansprüche, die ferner eine Anzahl von elastischen Schichten (36) umfaßt.

5. Eine supraleitende Struktur gemäß irgendeinem der vorhergehenden Ansprüche, bei der jede Untereinheit (30) einen keramischen Supraleiter umfaßt.

6. Eine supraleitende Struktur gemäß irgendeinem der vorhergehenden Ansprüche, in Kombination mit einem magnetischem Läufer.

7. Eine Anzahl von supraleitenden Strukturen gemäß irgendeinem der vorhergenden Ansprüche, die in einer Anordnung angeordnet sind, wobei ihre Mittelachsen im wesentlichen parallel sind.

## Revendications

1. Structure supraconductrice comportant une disposition, en damier, de sous-organes supraconducteurs distincts (30) structure caractérisée par le fait que chaque sous-organe (30) a la forme d'un disque de Bitter.

2. Structure supraconductrice selon la revendication 1, dans laquelle chaque sous-organe (30) est électriquement connecté aux sous-organes qui lui sont immédiatement adjacents de façon à former un aimant supraconducteur (40).

3. Structure supraconductrice selon la revendication 1 ou la revendication 2, comportant en outre un certain nombre de couches de substrat isolant pour isoler électriquement les sous-organes (30) les uns des autres.

4. Structure supraconductrice selon l'une quelconque des revendications précédentes, comportant en outre un certain nombre de couches élastiques (36).

5. Structure supraconductrice selon l'une quelconque des revendications précédentes, dans laquelle chaque sous-organe (30) comporte un supraconducteur céramique.

6. Structure supraconductrice selon l'une quelconque des revendications précédentes, en combinaison avec une armature magnétique.

7. Un certain nombre de structures supraconductrices selon l'une quelconque des revendications précédentes, disposées selon une distribution avec leurs axes centraux substantiellement parallèles.
